# EUROPÄISCHE PATENTSCHRIFT

(11) **EP 2 795 798 B1**
(45) Veröffentlichungstag und Bekanntmachung des Hinweises auf die Patenterteilung: **15.07.2015**
(21) Anmeldenummer: 13798982.8
(22) Anmeldetag: 22.11.2013
(51) Int. Cl.: H03K 17/955, H03K 17/96

(54) **EINRICHTUNG UND VERFAHREN ZUR AUSWERTUNG DER KAPAZITÄT EINER SENSORELEKTRODE EINES ANNÄHERUNGSSENSORS**
DEVICE AND METHOD FOR EVALUATING THE CAPACITANCE OF A SENSOR ELECTRODE OF A PROXIMITY SENSOR
SYSTÈME ET PROCÉDÉ D'ÉVALUATION DE LA CAPACITÉ D'UNE ÉLECTRODE DE DÉTECTION D'UN DÉTECTEUR DE PROXIMITÉ

(30) Priorität: 18.12.2012 DE 102012112479
(43) Veröffentlichungstag der Anmeldung: 29.10.2014
(73) Patentinhaber: Huf Hülsbeck & Fürst GmbH & Co. KG, 42551 Velbert (DE)
(72) Erfinder: SIEG, Berthold, 46240 Bottrop (DE)
(74) Vertreter: Zenz Patentanwälte Partnerschaft mbB
(86) Internationale Anmeldenummer: PCT/EP2013/074449
(87) Internationale Veröffentlichungsnummer: WO 2014/095224

(56) Entgegenhaltungen:
- EP-A2- 2 442 447
- WO-A2-2010/045662
- US-A1- 2007 046 299
- US-A1- 2011 210 753

## Beschreibung

Die Erfindung betrifft ein Verfahren und eine zugehörige Schaltung zum Erfassen von Kapazitäten und Kapazitätsänderungen an Sensorelektroden.

Kapazitive Annäherungsschalter sind im Stand der Technik im Anwendungsbereich für Fahrzeuge bekannt. Beispielsweise offenbart die EP 1505734 einen kapazitiven Näherungsschalter und ein zugehöriges Auswerteverfahren. Kapazitive Näherungsschalter weisen Sensorelektroden auf und sprechen an, wenn zwischen der Sensorelektrode und einer Bezugselektrode eine bestimmte Kapazität oder Kapazitätsänderung erfasst wird. Häufig werden dafür mehrere Elektroden in einem zur Bedienungserfassung ausgelegten Bereich eines Fahrzeuges angeordnet.

Die Sensorelektrode wird zur Erfassung auf ein vorgegebenes Potential gebracht und bildet mit einer Referenzelektrode, z.B. der Fahrzeugmasse oder der Masse des unter dem Fahrzeug befindlichen Bodens eine Kapazität aus. Diese Kapazität ist veränderbar, wenn sich in dem sensitiven Bereich der Sensoranordnung ein Körper bewegt, beispielsweise die Hand eines Benutzers oder der Fuß eines Benutzers.

Für diesen Effekt gibt es grundsätzlich verschiedene Betrachtungsweisen. Einerseits wird das Dielektrikum um die Sensorelektrode herum verändert, andererseits bildet der Körper des Bedieners eine (leitfähige) Elektrode, so dass seine Annäherung einer Einkopplung einer weiteren Kapazität entspricht. In jedem Fall führt die durch das Bedienerkörperteil herbeigeführte Änderung der Umgebung der Sensorelektrode zu einer Änderung des elektrischen Feldes und zu Ladungsverschiebung und somit der messbaren Kapazität. Unabhängig von der Betrachtungsweise ist jedoch die kurzfristig veränderliche Kapazität der Sensorelektrode erfassbar und signalisiert Veränderungen der Umgebung.

Die Erfassung der Kapazität selbst ist auf verschiedene Weise möglich. Beispielsweise kann als Messwert für die Kapazität eine Anzahl getakteter Entladevorgänge oder eine Entladezeitdauer verwendet werden. Derartige Auswerteverfahren sind im Stand der Technik bekannt. Beispielsweise ist auch aus der DE 19617038A1 eine kapazitive Erfassung einer Annäherung an einen Fahrzeugtürgriff bekannt.

Die WO 2010/045662 A2 offenbart auch ein Verfahren zum Auswerten der Kapazität einer Sensorelektrode eines Annäherungssensors, wobei die Kapazität durch Zuschaltung einer Kompensationskapazität beeinflusst wird.

Andere Konzepte für eine Kapazitätsauswertung sind z.B. in der US 2007/0046299 A1, der EP 2442447 A2 und der US 2011/0210753 A1 offenbart.

Bei den bekannten Sensoranordnungen ist es problematisch, dass äußere Einflüsse dazu führen, dass sich die an der Sensorelektrode gemessene Kapazität auch dann ändern kann, wenn sich gar kein Benutzer annähert. Die Kapazität einer Sensorelektrode hängt stark von der Umgebung, beispielsweise der Luftfeuchtigkeit, oder einer Belegung mit Regen, Schnee, Eis oder Schmutz im Bereich der Sensorelektrode ab. In diesem Zusammenhang ist beispielsweise aus der DE 19620059A1 ein kapazitiver Näherungsschalter bekannt, der nur dann schaltet, wenn sich die Kapazität zwischen Ansprechelektrode und der Bezugselektrode mit einer Geschwindigkeit ändert, die größer als ein unterer Grenzwert ist.

Diese Konzepte ändern jedoch nichts daran, dass die Auswerteschaltung üblicherweise auf einen Arbeitspunkt ausgelegt ist, der einer erwarteten auszuwertenden Kapazität oder Änderung der Kapazität entspricht. Wird die Kapazität durch äußere Einflüsse erheblich verändert, sinkt auch die Genauigkeit der Auswertung, da die Auslegung der Schaltung nicht mehr mit dem Grundwert der Kapazität korrespondiert.

Des Weiteren ist es jederzeit wünschenswert, eine Optimierung der Auswerteschaltungen hinsichtlich Erfassungsgeschwindigkeit und Reduktion der Anzahl oder des Preises der verwendeten Bauteile oder der Baukosten vorzunehmen.

Aufgabe der Erfindung ist es, eine verbesserte Auswerteschaltung für die Kapazitätserfassung an Sensorelektroden zur Verfügung zu stellen.

Diese Aufgabe wird durch ein Verfahren gemäß Anspruch 1 und eine Einrichtung nach Anspruch 7 gelöst.

Gemäß der Erfindung werden ein Verfahren und eine Einrichtung vorgeschlagen, wobei ein Ladungstransfer von einer zu vermessenden Sensorelektrode mit einer zu bestimmenden Kapazität vorgenommen wird.

Wie unten ausführlich beschrieben wird, wird dafür eine für die Kapazität repräsentative Ladung auf einer Hilfskapazität oder Haltekapazität über mehrere Messzyklen akkumuliert.

Das Verfahren basiert grundsätzlich auf dem Konzept, für jede Erfassung einer Kapazität mehrere Zyklen des Umladungsverfahrens auszuführen, wobei in jedem Zyklus Ladung einer im System festgelegten Haltekapazität verschoben wird. Nach Durchführung einer vorgegebenen Anzahl von Zyklen wird die akkumulierte Ladung der Haltekapazität ausgewertet.

Jeder der Zyklen besteht wiederum aus mehreren Phasen. Dabei wird erfindungsgemäß während einer ersten Phase die kapazitive Sensorelektrode über eine erste Schalteinrichtung mit einer Ladespannung gekoppelt. Dies führt zu einer Aufladung der Sensorelektrode. Die Ladung auf der Sensorelektrode entspricht nach erfolgter Aufladung dem bekannten Zusammenhang zwischen aktueller Kapazität und Ladespannung (Ladung=Kapazität*Spannung).

Unter dem Begriff Schalteinrichtung ist im Rahmen dieser Erfinder allgemein eine ansteuerbare Einrichtung zum gezielten Koppeln, Entkoppeln und Umkoppeln elektrischer Einrichtungen zu verstehen. Es sind also insbesondere elektronische und mechanische Schalter, z.B. auch einpolige und mehrpolige Wechselschalter gemeint.

Gleichzeitig wird in dieser ersten Phase, unabhängig von der Ladung der Sensorelektrode, eine Kompensationskapazität mittels einer weiteren, zweiten Schalteinrichtung zwischen eine Referenzspannung und Masse eingekoppelt. Dabei wird die Referenzkapazität gemäß der eigenen Kapazität und der Größe der Referenzspannung mit Ladung belegt.

Diese beiden Vorgänge, also die Ladung der Sensorelektrode und die Ladung der Kompensationskapazität, geschehen in der ersten Phase etwa gleichzeitig und unabhängig voneinander. Die Ladespannung und die Referenzspannung können außerdem gleich oder unterschiedlich sein.

In einer folgenden zweiten Phase des Zyklus wird die Kopplung zwischen der Ladespannung und der Sensorelektrode unterbrochen, die zugehörige erste Schalteinrichtung wird dafür betätigt. Außerdem wird die Kopplung der Kompensationskapazität zwischen Referenzspannung und Masse mittels der weiteren Schalteinrichtung unterbrochen.

Dann wird über eine Schalteinrichtung, (welche mit der ersten Schalteinrichtung ausgebildet sein kann oder eine separate Schalteinrichtung ist), die Sensorelektrode mit der Kompensationskapazität derart gekoppelt, dass es zu einem Ladungsausgleich zwischen den Kapazitäten der Sensorelektrode und der Kompensationskapazität kommt. Der Ladungsfluss, der sich einstellt, hängt dabei einerseits von dem Größenverhältnis der Kapazität der Sensorelektrode und der Kompensationskapazität ab und andererseits von der Lade- und Referenzspannung und damit der Voraufladung der Kompensationskapazität und der Sensorelektrode in der vorhergehenden Phase.

Als Schalter können unterschiedliche Bauteile verwendet werden, vorzugsweise handelt es sich um nicht-brückende Schalter, also "break before make" Schalteinrichtungen.

Hat sich dieser Ladungsausgleich eingestellt oder nach einer vorgegebenen Wartezeit, startet die dritte Phase, nämlich die Phase der eigentlichen Auswertung.

Nun wird die Sensorelektrode durch Betätigung der ersten Schalteinrichtung wieder von der Kompensationskapazität entkoppelt (und z.B. erneut mit der Ladespannung gekoppelt). Auf der Kompensationskapazität befindet sich weiterhin eine Ladung, die durch den Ladungsausgleich zwischen der Sensorelektrode und der Kompensationskapazität hergestellt wurde. Durch eine weitere Schalterschließung, also eine dritte Schalteinrichtung, wird nun die Kompensationskapazität mit einem Ladungs-Akkumulationsnetzwerk derart gekoppelt, dass ein Ladungsabfluss von der Kompensationskapazität durch das Akkumulationsnetzwerk erfolgt, der entstehende Stromfluss verstärkt wird und zu einer Umladung einer Haltekapazität im Akkumulationsnetzwerk führt. Entsprechend wird der Ladungszustand der Haltekapazität von Zyklus zu Zyklus schrittweise verändert.

Dies kann beispielsweise, wie unten näher beschrieben wird, durch Leitung des Stromes aus der Kompensationskapazität durch die Basis eines Transistors erfolgen, mit dem die Haltekapazität im Emitter-Kollektor-Strang gekoppelt ist. Der durch den Stromfluss durch die Kompensationskapazität bewirkte Stromfluss durch die Haltekapazität lädt letztere auf oder um, wobei der dadruch bewirkte Ladezustand der Haltekapazität anschließend weitgehend erhalten bleibt.

Mit Abschluss dieser dritten Phase ist ein Zyklus vollendet. Um den nächsten Zyklus zu beginnen, wird anschließend wieder eine Entkopplung der Kompensationskapazität von dem Akkumulationsnetzwerk durch Schalteröffnung der dritten Schalteinrichtung vorgenommen und die Kompensationskapazität wird wieder durch Schaltung der weiteren Schalteinrichtung mit der Referenzspannung zur Aufladung oder Entladung gekoppelt. Dann beginnt der nächste Zyklus wiederum mit Phase eins, die bereits oben beschrieben wurde.

Nach Ausführung einer Anzahl von derartigen Zyklen, beispielsweise 5 bis 20 Zyklen, befindet sich auf der Haltekapazität eine Ladung, die repräsentativ für die Kapazität der Sensorelektrode gegenüber der Umgebung ist. Ein repräsentativer Wert kann nun durch eine Spannungsmessung an der Haltekapazität abgegriffen werden und es wird ein Messwert für die Sensorkapazität gespeichert. Anschließend wird die Haltekapazität wieder in den ursprünglichen Ladungszustand gebracht, also z.B. kurzzeitig mit Masse gekoppelt, und die nächste Anzahl von Messzyklen kann beginnen.

Das erfindungsgemäße Verfahren und die erfindungsgemäße Vorrichtung zeichnen sich durch mehrere Vorteile gegenüber bekannten Verfahren aus. Ein wesentlicher Vorteil besteht darin, dass bei der eigentlichen Ladungsakkumulation auf der Haltekapazität die Sensorelektrode von dem Auswertungsvorgang bereits wieder entkoppelt ist. Die Sensorelektrode trägt oft störende Einflüsse in das System, da sie einerseits exponiert liegt und andererseits durch Leitungslängen und Umwelteinflüsse stark beeinflusst ist. Gemäß der Erfindung wird die Umladung von der Sensorelektrode auf die vorgeladene Kompensationskapazität vorgenommen, dann die Kopplung mit der Sensorelektrode unterbrochen (galvanisch getrennt) und erst dann wird eine Auswertung der auf die Kompensationskapazität vorhandenen Ladung vorgenommen. Das Verfahren ist damit sensitiver und dennoch weniger anfällig für Störungen.

Außerdem ist das Verfahren mit optimierter Messzeit möglich, beispielsweise werden für die Erfassung von acht Messzyklen Zeiten von weniger als einer Millisekunde benötigt.

Schließlich kommt es auch zu deutlich weniger elektromagnetischer Abstrahlung als bei bekannten Verfahren, da hier nur kurze Pulse auftreten, im Wechsel mit langen Pausen.

Von welcher baulichen Gestaltung das Akkumulationsnetzwerk ist, kann vom Fachmann im Rahmen der Erfindung gewählt werden. Wesentlich ist, dass die auf die Kompensationskapazität umgeladene Ladung bei Kopplung mit dem Kompensationsnetzwerk einen abhängigen Strom hervorruft, welcher die Haltekapazität umlädt, beispielsweise einen proportional verstärkten Strom. In dem unten stehenden Ausführungsbeispiel ist eine mögliche und einfache Gestaltung eines Kompensationsnetzwerkes gezeigt. Dabei wird die Haltekapazität einerseits mit der Ladespannung gekoppelt und andererseits in den Emitter-Kollektor-Strang eines bipolaren Transistors und über einen Widerstand und die dritte Schalteinrichtung mit Masse geschaltet. Sperrt der Transistor, ist die Ladung auf dem Haltewiederstand fixiert und gleichsam eingefroren. Wird jedoch über eine Schalterschließung die Basis des Transistors mit der aufgeladenen Kompensationskapazität gekoppelt und der Stromfluss durch den Transistor freigegeben, erfolgt eine Umladung der Haltekapazität, welche zu dem Stromfluss durch die Basis korreliert.

Wesentlich ist, dass die Schaltvorgänge der genannten Schalteinrichtungen in einer Abfolge derart erfolgen, dass die Phasen der Auswertung klar getrennt sind. Entsprechend sieht die Erfindung für jeden Sensor einen Schalter vor, der die Sensorelektrode mit der Kompensationskapazität koppelt. Außerdem ist für jede Kompensationskapazität eine Schalteinrichtung vorzusehen, um diese gezielt mit dem Akkumulationsnetzwerk zu koppeln.

Mehrere Sensoren können sich dabei zeitversetzt eine Kompensationskapazität teilen, ebenso wir ein gemeinsames Akkumulationsnetzwerk.

In einer Weiterbildung der Erfindung ist die Kompensationskapazität oder deren Aufladung im Zuge von dem Auswerteverfahren anpassbar. Aufgrund von veränderten Umweltbedingungen kann sich die Kapazität der Sensorelektrode verändern. Durch Verschmutzung oder Befeuchtung der Umgebung der Sensorelektrode ändert sich die zu ermittelnde Kapazität. Da nur Kapazitätsänderungen für die Erfassung von Benutzungen relevant sind und nicht die absolute Kapazität, ist eine Anpassung der Schaltung auf die aktuelle Grundkapazität der Sensorelektrode wünschenswert.

Im Rahmen der Erfindung ist es dafür möglich, die Referenzspannung der Kompensationskapazität veränderlich zu gestalten. In Abhängigkeit von der Referenzspannung wird eine wählbare Ladung auf die Kompensationskapazität gebracht (Phase 1), welche anschließend (in Phase 2) für den Ladungsausgleich mit der Sensorelektrode zur Verfügung steht. Wird die Referenzspannung verändert, wird auch die auf die Kompensationskapazität gebrachte Ladung verändert und es stellt sich nach dem Ladungsausgleich eine andere, mit dem Akkumulationsnetzwerk zu koppelnde Ladung dar. Damit ist eine Art Offset-Korrektur der Ladung auf der Sensorelektrode möglich.

In der Praxis wird für die Anpassung der Referenzspannung erfindungsgemäß nach Abschluss der vorgegebenen Zyklenzahl die Ladung auf der Haltekapazität ausgewertet (beispielsweise durch Spannungsabgriff) und es wird ermittelt, ob sich dieser Wert in einem Zielbereich um einen Arbeitspunkt herum befindet. Wird festgestellt, dass die Kapazität der Sensorelektrode zu einer Seite von dem gewünschten Arbeitspunkt wegläuft (ohne dass dies eine Betätigung signalisiert, also mit größerer Zeitkonstante), kann über die Anpassung der Referenzspannung an der Kompensationskapazität gegengesteuert werden. Dies führt zu einer erhöhten Auswertegenauigkeit und Sensitivität, da das Auswertenetzwerk, also das Akkumulationsnetzwerk, auf einen engeren Arbeitsbereich eingestellt werden kann, indem die auszuwertenden Daten zurückgeführt werden.

In einer Weiterbildung der Erfindung sind mehrere Kompensationskapazitäten zur Kompensation zuschaltbar, ebenfalls um die auszuwertenden Ladungsmengen in einem Arbeitsbereich zu halten. Zur Zuschaltung weiterer Kompensationskapazitäten können weitere Kapazitätsstrenge zugeschaltet werden oder es können veränderliche Kapazitäten eingesetzt werden.

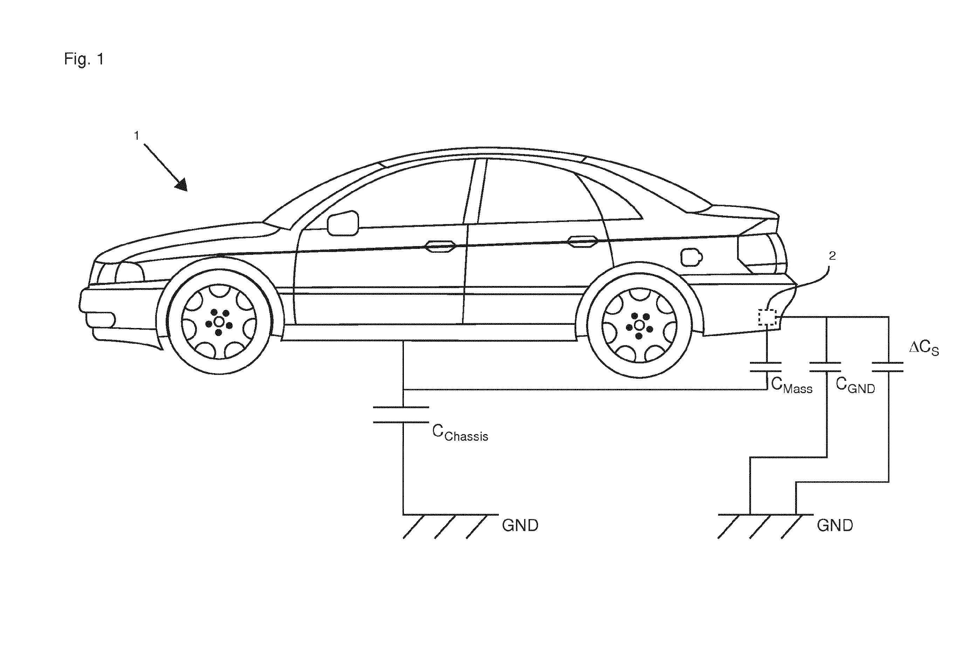

In Figur 1 ist ein Fahrzeug 1 dargestellt, welches im Heckbereich einen kapazitiven Sensor 2 aufweist. Der Sensor 2 ist als Sensorelektrode ausgebildet, die im hinteren Stoßfänger des Fahrzeugs angeordnet ist. Bei Betätigungswunsch an einer Kofferraumabdeckung kann ein Benutzer eine Bewegungsgeste ausführen, insbesondere den Fuß unter das Fahrzeugheck bewegen, damit die Kapazität der Sensorelektrode verändern und so die Öffnung des Kofferraums auslösen.

Die Elektrode erstreckt sich in der Fahrzeugbreite über den gesamten Stoßfänger oder einen bestimmten Teilabschnitt, in welchem der Benutzer die Geste auszuführen hat.

In der Abbildung sind schematisch die zu berücksichtigenden Kapazitäten des Fahrzeugs gezeigt. Gegenüber dem tatsächlichen Erdpotential weist das Chassis des Fahrzeugs eine Kapazität auf, die regelmäßig um Größenordnungen größer ist als die übrigen Kapazitäten. Die Kapazität C_{Chassis} beträgt üblicherweise mehrere 100 pF oder auch noch höhere Kapazitäten. Für die folgende Betrachtung ist entsprechend dieser Kapazität des Fahrzeugchassis gegenüber dem Erdpotential regelmäßig vernachlässigbar, da das Fahrzeugchassis selbst gegenüber der Sensorelektrode eine Fahrzeugmasse bildet, welche in der schematischen Darstellung als C_{Mass} bezeichnet ist.

Des Weiteren weist die Sensorelektrode 2 eine Kapazität gegenüber dem Erdpotential auf, diese beträgt einige pF z. B. etwa 5 pF. Entsprechend gilt in dieser schematischen Betrachtung C_{GND} gleich 5 pF.

Außerdem wird eine veränderliche Kapazität ΔC_{S} parallel zu C_{GND} wirken. Diese veränderliche Kapazität ist abhängig von Umgebungsbedingungen oder auch der Bewegung eines Körpers in dem Umgebungsbereich der Sensorelektrode 2. Für diesen Effekt gibt es grundsätzlich verschiedene Betrachtungsweisen, einerseits wird das Dielektrikum um die Sensorelektrode 2 herum verändert, andererseits kann eine Einkopplung einer weiteren Kapazität (Körper des Bedieners) parallel zu C_{GND} zu einer Erklärung herangezogen werden. Unabhängig von der Betrachtungsweise ist jedoch die Kapazität ΔC_{S} diejenige Kapazität, welche für die Betätigungserkennung detektiert werden soll. Hierbei ist die Kapazität ΔC_{S}, also die Veränderung der Kapazität durch äußere Einflüsse oder Betätigung deutlich geringer als die Kapazität C_{GND}. Üblicherweise beträgt die Kapazität ΔC_{S} weniger als ein pF, beispielsweise weniger als 0,5 pF.

Die Kapazität C_{GND} wird durch Umwelteinflüsse, beispielsweise trocknendes Salzwasser, Schmierbeläge oder auch Lackaufträge auf dem Stoßfänger verändert. Wenn die Kapazität C_{GND} erhöht wird, ist die tatsächliche Detektionskapazität ΔC_{S} schwerer zu erfassen. Die Feldlinien des elektrischen Feldes, welches durch die Sensorelektrode 2 hervorgerufen wird, werden durch derartige Störungen, insbesondere leitende Schichten stark beeinflusst und erstrecken sich nicht mehr ausreichend in den Detektionsbereich.

Es ist daher wichtig, kleine Kapazitätsänderungen zu erkennen, auch wenn die jederzeit vorliegende Basiskapazität veränderlich ist.

Die Erfindung setzt hierbei an, indem in Abhängigkeit von den erfassten Messwerten eine Verschiebung des Arbeitspunktes der Schaltung möglich ist.

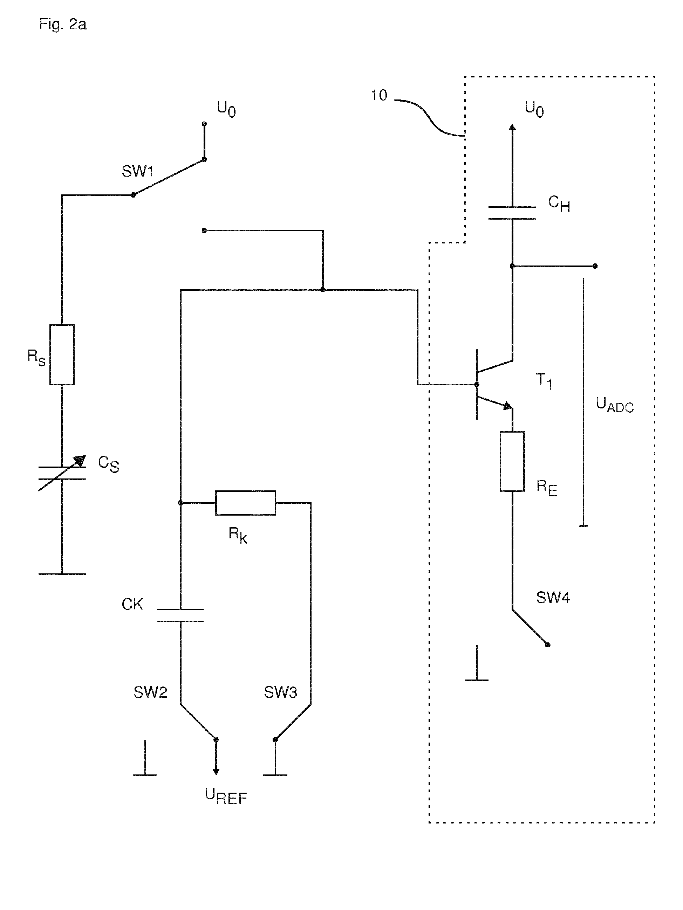

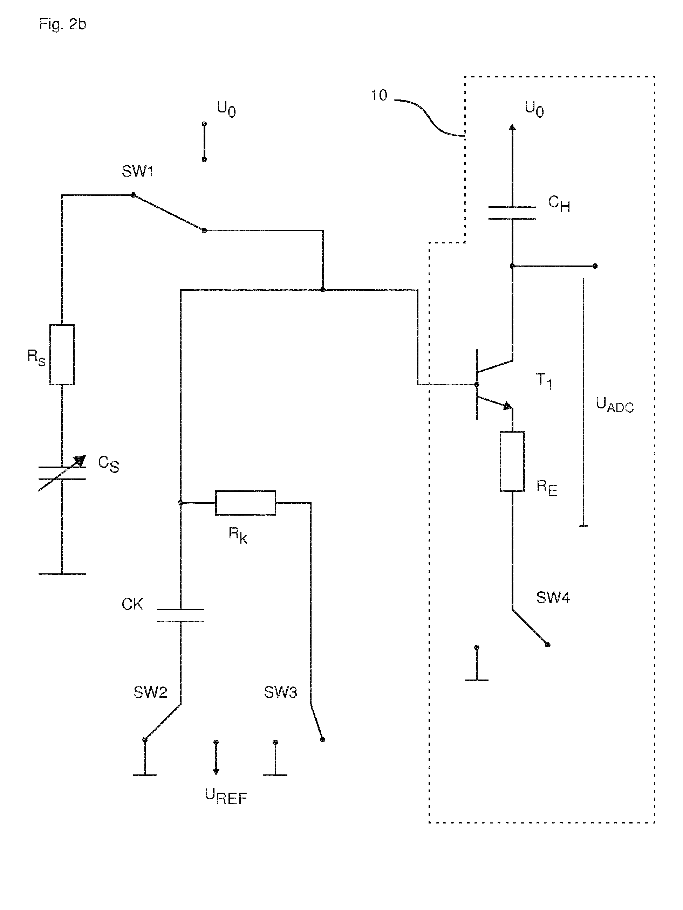

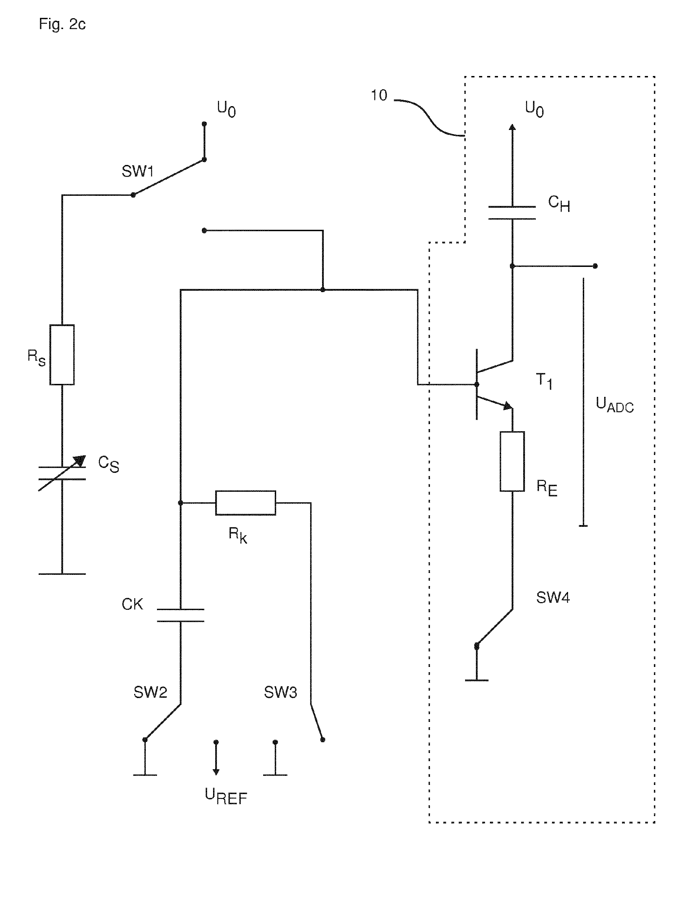

Die Figuren 2a, 2b und 2c zeigen die drei Phasen eines Auswertevorgangs, also eines Zyklus der mehreren durchzuführenden Zyklen.

Figur 2a zeigt die Phase 1, bei der eine Schalteinrichtung SW1 über einen Widerstand R_{S} die Sensorelektrode, hier dargestellt durch die veränderliche Kapazität C_{S} mit der Ladespannung U₀ koppelt. In dieser Phase wird die Kapazität C_{S} entsprechend ihrer aktuellen Kapazität und der Ladespannung U₀ geladen. In einem davon unabhängigen Bereich wird gleichzeitig die Kapazität C_{K} über die Schalteinrichtungen SW2 und SW3 und einem Widerstand R_{K} mit der Referenzspannung U_{Ref} und Masse gekoppelt. Auch hier wird die Kapazität aufgeladen, entsprechend der angelegten Referenzspannung U_{Ref} und der Kapazität C_{K}. Zwar ist die Kapazität C_{K} grundsätzlich auch mit dem Akkumulationsnetzwerk 10 gekoppelt, dort kann jedoch kein Stromfluss erfolgen, da in dem Akkumulationsnetzwerk 10 die Schalteinrichtung SW4 geöffnet ist. Ein Stromfluss durch das Akkumulationsnetzwerk 10 ist daher nicht möglich.

Das Akkumulationsnetzwerk 10 setzt sich aus mehreren Komponenten zusammen, wobei die Haltekapazität C_{H} einerseits mit der Ladespannung U₀ gekoppelt ist und andererseits mit dem Transistor T₁. Es handelt sich hierbei um einen bipolaren Transistor, der über den Widerstand R_{E} und die Schalteinrichtung SW4 mit Masse koppelbar ist. In dem hier gezeigten Zustand ist jedoch die Schalteinrichtung SW4 geöffnet, so dass keine Ladungsänderung auf der Haltekapazität C_{H}, insbesondere kein Ladungsabfluss oder -zufluss möglich ist.

Ebenfalls schematisch dargestellt ist, dass der Zustand der Haltekapazität C_{H} über einen Spannungsabgriff der Spannung U_{ADC} auswertbar ist, wenn eine Mehrzahl an Zyklen für die Ermittlung der Kapazität C_{S} erfolgt ist. Nach einer vorgegebenen Zeitdauer, wenn von der abgeschlossenen Ladung der Kapazitäten C_{S} und C_{K} auszugehen ist, werden die Schalteinrichtungen SW1, SW2 und SW3 betätigt. Bei diesem Ausführungsbeispiel handelt es sich Schalteinrichtungen mit break-before-make Eigenschaft. Es ist wesentlich, dass keine Phase eine unerwünschte Kopplung vorliegt. Insbesondere sollten die Schalteinrichtungen SW1 einerseits und SW2 und SW3 andererseits zumindest kurzzeitig gleichzeitig geöffnet sein, bevor ein erneuter Schalterschluss erfolgt.

Fig. 2b zeigt die zweite Phase des Auswertungszyklus. Nach erfolgtem Schaltvorgang ist über die Schalteinrichtung SW1 die Kapazität C_{S} mit der Kapazität C_{K} gekoppelt. Die Schalteinrichtung SW3 ist geöffnet und ein Ladungsabfluss zur Masse über den Widerstand R_{K} kann nicht mehr erfolgen. Über die Schalteinrichtung SW2 ist andererseits die Kapazität C_{K} mit Masse gekoppelt, so dass ein Ladungsausgleich zwischen C_{S} und C_{K} erfolgen kann.

Die Schalteinrichtung SW4 ist weiterhin geöffnet, ein Ladungsabfluss durch das Akkumulationsnetzwerk 10 ist weiterhin nicht möglich. Im Zustand der Figur 2b wird sich also nach kurzer Zeit ein stabiler Ladungszustand der Kapazität C_{S} und C_{K} ausbilden.

Figur 2c zeigt die nächste Phase des Auswertevorganges. Die Schalteinrichtung SW1 wird erneut betätigt und entkoppelt die Kapazität C_{S} wieder von der Kapazität C_{K}. Die auf dem Kondensator C_{K} vorhandene Kapazität nach dem Ladungsausgleich bleibt dort vorhanden, ein Ladungsabfluss ist zunächst nicht möglich. Die Schalteinrichtung SW1 koppelt die Kapazität C_{S} wieder mit der Ladespannung U₀ und es erfolgt wieder, wie im Ausgangszustand der Figur 2a, eine Aufladung der Kapazität C_{S} entsprechend ihrer aktuellen Kapazität.

Nun wird die Schalteinrichtung SW4 zur Kopplung des Akkumulationsnetzwerkes mit Masse geschlossen, der Stromfluss durch das Akkumulationsnetzwerk wird damit freigegeben. Die Kapazität C_{K} ist mit der Basis des Transistors T₁ gekoppelt und die Ladung kann von C_{K} nun durch die Basis des Transistors T₁ abfließen. Ein verstärkter Stromfluss geht nun durch den Basis-Emitterstrang des Transistors T1, um die Kapazität C_{H} umzuladen. Dies geschieht nur solange, wie ein Stromfluss, ausgehend von der Kapazität C_{K} durch das Akkumulationsnetzwerk zur Masse vorhanden ist. Es ist zu beachten, dass C_{K} immer noch mit Masse gekoppelt ist. Die Kapazität C_{H} wird also soweit umgeladen, wie dies der Ladungsmenge nach Ladungsausgleich auf der Kapazität C_{K} entspricht. Nach kurzer Zeit kann dann der Schalter SW4 wieder geöffnet werden, was einen Stromfluss durch die Basis und dem Transistor unterbindet und die Kapazität C_{H} verbleibt auf ihrem Ladungszustand.

Werden diese Phasen der Auswertung aus den Figuren 2a, 2b, 2c mehrfach wiederholt, akkumuliert sich auf der Kapazität C_{H} eine Ladung, die für die Ladung auf der Kapazität C_{S}, also der Sensorelektrode, repräsentativ ist.

Es ist außerdem ersichtlich, dass die Sensorelektrode C_{S}, die oft zu Störungen in der Auswerteelektronik führt, während des eigentlichen Auswertevorganges, also der Kopplung mit dem Akkumulationsnetzwerk 10, vollständig von der Auswertung entkoppelt ist.

Außerdem ist erkennbar, dass in diesem einfachen Aufbau eine Veränderung der Spannung U_{Ref} eine Veränderung der Ladung auf der Kompensationskapazität mit sich bringt. Es ist möglich, durch die Veränderung dieser Spannung eine Rückführung in einem Arbeitsbereich vorzunehmen, auf den das Akkumulationsnetzwerk 10 ausgelegt ist.

Die Anzahl der Bauteile, die für diese Einrichtung verwendet werden, ist gering und die Verlässlichkeit und Sensitivität des Netzwerkes ist besonders vorteilhaft.

## Patentansprüche

1. Verfahren zum Auswerten der Kapazität (C_{S}) einer Sensorelektrode eines Annäherungssensors, mit den Schritten:
Laden der Sensorelektrode durch Koppeln der Sensorelektrode mit einer Ladespannung (U₀) mittels einer Sensorelektroden-Schalteinrichtung (SW1),
Laden einer Kompensationskapazität (C_{K}) durch Einkoppeln der Kompensationskapazität zwischen eine Referenzspannung (U_{REF}) und Masse mittels einer Kompensationskapazitäts-Schalteinrichtung (SW2, SW3),
Entkoppeln der Sensorelektrode von der Ladespannung (U₀) mittels der Sensorelektroden-Schalteinrichtung (SW1) und Entkoppeln der Kompensationskapazität (C_{K}) von der Referenzspannung mittels der Kompensationskapazitäts-Schalteinrichtung (SW2, SW3), wobei ein Ladungszustand der Sensorelektrode und der Kompensationskapazität erhalten wird,
Koppeln der Sensorelektrode mit der Kompensationskapazität (C_{K}) mittels der Sensorelektroden-Schalteinrichtung (SW1), um einen Ladungsausgleich zwischen der durch die Sensorelektrode gebildeten Kapazität (C_{S}) und Kompensationskapazität zu bewirken,
Entkoppeln der Sensorelektrode von der Kompensationskapazität (C_{K}) mittels der Sensorelektroden-Schalteinrichtung (SW1), wobei die durch den Ladungsausgleich vorliegende Ladung der Kompensationskapazität erhalten wird,
Koppeln der Kompensationskapazität (C_{K}) mit einem Auswertenetzwerk mittels einer Auswertenetzwerk-Schalteinrichtung (SW4), um einen Stromfluss von der Kompensationskapazität durch das Auswertenetzwerk zu bewirken,
Umladen einer Haltekapazität (C_{H}) in dem Auswertenetzwerk mit einem vom Stromfluss der Kompensationskapazität abhängigen Umladestrom.

2. Verfahren nach Anspruch 1, wobei die Schritte über mehrere Zyklen wiederholt werden, um eine wiederholte Umladung der Haltekapazität (C_{H}) und eine Ladungsakkumulation auf der Haltekapazität zu bewirken, wobei vor Wiederholung der Schritte:
die Kompensationskapazität (C_{K}) von dem Auswertenetzwerk entkoppelt wird,
die Sensorelektrode erneut mit der Ladespannung gekoppelt wird und
die Kompensationskapazität erneut zwischen Referenzspannung und Masse eingekoppelt wird.

3. Verfahren nach einem der Ansprüche 1 oder 2, wobei der Ladezustand der Haltekapazität ausgewertet wird, um einen Messwert für die Kapazität der Sensorelektrode zu erhalten.

4. Verfahren nach Anspruch 3, wobei in Abhängigkeit von dem Messwert die Referenzspannung (U_{REF}) in ihrer Größe verändert wird.

5. Verfahren nach Anspruch 3 oder 4, wobei in Abhängigkeit von dem Messwert die Kompensationskapazität (C_{K}) in Ihrer Größe verändert wird.

6. Verfahren nach einem der Vorangehenden Ansprüche, wobei der Stromfluss von der Kompensationskapazität (C_{K}) zum Umladestrom der Haltekapazität (C_{H}) verstärkt wird.

7. Sensoreinrichtung zu Erfassung von Annäherungen mit einer kapazitiven Sensorelektrode, wobei
eine Sensorelektroden-Schalteinrichtung (SW1) vorgesehen ist und die Sensorelektrode mit der Sensorelektroden-Schalteinrichtung gekoppelt ist,
wobei eine Ladespannungsquelle (U0) mit der Sensorelektroden-Schalteinrichtung (SW1) gekoppelt ist,
wobei eine Kompensationskapazität (C_{K}) ausgebildet ist, die mit wenigstens einer Kompensationskapazitäts-Schalteinrichtung (SW2, SW3) gekoppelt ist,
wobei eine Referenzspannungsquelle (U_{REF}) mit der Kompensationskapazitäts-Schalteinrichtung gekoppelt ist,
wobei die Kompensationskapazitäts-Schalteinrichtung (SW2, SW3) ansteuerbar ist, um die Kompensationskapazität entweder zum Laden der Kompensationskapazität mit der Referenzspannungsquelle (U_{REF}) und Masse zu koppeln oder zum Erhalten der Ladung von der Referenzspannungsquelle (U_{REF}) zu entkoppeln,
wobei ein Auswertenetzwerk ausgebildet ist, welches über einer Auswertenetzwerk-Schalteinrichtung (SW4) mit der Kompensationskapazität (C_{K}) koppelbar ist, wobei das Auswertenetzwerk wenigstens eine Haltekapazität (C_{H}) aufweist,
wobei die Sensorelektroden-Schalteinrichtung (SW1) ansteuerbar ist, um die Sensorelektrode zumindest mit der Ladespannungsquelle (U0) und alternativ mit der Kompensationskapazität zu koppeln,

8. Sensoreinrichtung nach Anspruch 7, wobei das Auswertenetzwerk ausgebildet ist, um einen Stromfluss von der Kompensationskapazität (C_{K}) durch das Auswertenetzwerk zu verstärken und die Haltekapazität mit dem verstärkten Stromfluss umzuladen.

9. Sensoreinrichtung nach Anspruch 7 oder 8, wobei die Referenzspannungsquelle (U_{REF}) als Spannungsquelle mit veränderbarer Gleichspannung ausgebildet ist.

10. Sensoreinrichtung nach einem der Ansprüche 7 bis 9, wobei die Kompensationskapazität (C_{K}) aus einem Kapazitätsnetzwerk gebildet ist, wobei verschiedene Kapazitäten zur Bildung der Kompensationskapazität zuschaltbar sind.

11. Sensoreinrichtung nach einem der Ansprüche 7 bis 10, wobei die Haltekapazität mit einem Spannungsabgriff zur Erfassung des Ladezustandes der Haltekapazität gekoppelt ist.

12. Sensoreinrichtung nach einem der vorangehenden Ansprüche, wobei die Kopplung des Auswertenetzwerkes mit der Kompensationskapazität über einen Transistor ausgebildet ist, wobei die Kompensationskapazität mit der Basis des Transistors koppelbar ist und wobei in dem Emitter-Kollektor-Strang des Transistors die Haltekapazität zwischen Transistor und eine Gleichspannungsquelle gekoppelt ist und auf der anderen Seite des Transistors die Masse mit dem Transistor koppelbar ist, so dass ein Stromfluss von der Kompensationskapazität durch die Transistorbasis einen verstärkten Umladestrom durch den Basis-Emitter Strang des Transistors bewirkt und damit durch den Haltekondensator.

## Claims

1. Method for evaluating the capacitance (C_{S}) of a sensor electrode of a proximity sensor, having the steps:
charging of the sensor electrode by coupling the sensor electrode to a charging voltage (U₀) using the sensor electrode switching device (SW1),
charging of a compensation capacitance (C_{K}) by coupling in the compensation capacitance between a reference voltage (U_{REF}) and ground using a compensation capacitance switching device (SW2, SW3),
decoupling of the sensor electrode from the charging voltage (U₀) using the sensor electrode switching device (SW1) and decoupling the compensation capacitance (C_{K}) from the reference voltage using the compensation capacitance switching device (SW2, SW3), wherein a charge state of the sensor electrode and the compensation capacitance is maintained,
coupling of the sensor electrode to the compensation capacitance (C_{K}) using the sensor electrode switching device (SW1), in order to effect a charge balancing between the capacitance (C_{S}) formed by the sensor electrode and the compensation capacitance,
decoupling of the sensor electrode from the compensation capacitance (C_{K}) using the sensor electrode switching device (SW1), wherein the charge of the compensation capacitance which is present due to the load balancing is maintained,
coupling of the compensation capacitance (C_{K}) to an evaluation network using an evaluation network switching device (SW4), in order to effect a current flow from the compensation capacitance through the evaluation network,
recharging of a hold capacitance (C_{H}) in the evaluation network with a recharge current dependent on the current flow from the compensation capacitance.

2. The method according to Claim 1, wherein the steps are repeated over a plurality of cycles, in order to effect a repeated recharging of the hold capacitance (C_{H}) and a charge accumulation on the hold capacitance, wherein before repetition of the steps:
the compensation capacitance (C_{K}) is decoupled from the evaluation network,
the sensor electrode is again coupled to the charging voltage and
the compensation capacitance is again coupled in between reference voltage and ground.

3. The method according to one of Claims 1 or 2, wherein the charge state of the hold capacitance is evaluated in order to obtain a measurement of the capacitance of the sensor electrode.

4. The method according to Claim 3, wherein the reference voltage (U_{REF}) is varied in size in accordance with the measurement.

5. The method according to Claim 3 or 4, wherein the compensation capacitance (C_{K}) is varied in size in accordance with the measurement.

6. The method according to any one of the previous claims, wherein the current flow from the compensation capacitance (C_{K}) is amplified to form the recharging current of the hold capacitance (C_{H}).

7. Sensor device for detecting proximities with a capacitive sensor electrode, wherein
a sensor electrode switching device (SW1) is provided and the sensor electrode is coupled to the sensor electrode switching device,
wherein a charge voltage source (U0) is coupled to the sensor electrode switching device (SW1),
wherein a compensation capacitance (C_{K}) is implemented which is coupled to at least one compensation capacitance switching device (SW2, SW3),
wherein a reference voltage source (U_{REF}) is coupled to the compensation capacitance switching device,
wherein the compensation capacitance switching device (SW2, SW3) can be driven in order to either couple the compensation capacitance to the reference voltage source (U_{REF}) and ground for charging the compensation capacitance, or to decouple it from the reference voltage source (U_{REF}) for maintaining the charge,
wherein an evaluation network is implemented which can be coupled to the compensation capacitance (C_{K}) via an evaluation network switching device (SW4), wherein the evaluation network comprises at least one hold capacitance (C_{H}),
wherein the sensor electrode switching device (SW1) can be driven in order to couple the sensor electrode at least to the charge voltage source (U0) and alternatively to the compensation capacitance.

8. The sensor device according to Claim 7, wherein the evaluation network is designed to amplify a current flow from the compensation capacitance (C_{K}) through the evaluation network and to recharge the hold capacitance with the increased current flow.

9. The sensor device according to Claim 7 or 8, wherein the reference voltage source (U_{REF}) is implemented as a voltage source with variable DC voltage.

10. The sensing device according to any one of Claims 7 to 9, wherein the compensation capacitance (C_{K}) is formed from a capacitance network, wherein different capacitances can be additionally connected to form the compensation capacitance.

11. The sensing device according to any one of Claims 7 to 10, wherein the hold capacitance is coupled to a voltage tap for detecting the charge state of the hold capacitance.

12. The sensing device according to any one of the previous claims, wherein the evaluation network is coupled to the compensation capacitance via a transistor, wherein the compensation capacitance can be coupled to the base of the transistor and wherein in the emitter-collector path of the transistor the holding capacitance is coupled between the transistor and a direct current voltage source and on the other side of the transistor the transistor can be coupled to ground, so that a current flow from the compensation capacitance through the transistor base effects an increased recharging current through the base-emitter path of the transistor, and thereby through the hold capacitance.

## Revendications

1. Procédé pour évaluer la capacité (C_{S}) d'une électrode de détection d'un détecteur de proximité, avec les étapes suivantes :
la charge de l'électrode de détection grâce au couplage de l'électrode de détection à une tension de charge (U₀) au moyen d'un dispositif de commutation d'électrode de détection (SW1),
la charge d'une capacité de compensation (C_{K}) par couplage de la capacité de compensation entre une tension de référence (U_{REF}) et la masse au moyen d'un dispositif de commutation de la capacité de compensation (SW2, SW3),
le découplage de l'électrode de détection de la tension de charge (U₀) au moyen du dispositif de commutation d'électrode de détection (SW1) et le découplage de la capacité de compensation (C_{K}) de la tension de référence au moyen du dispositif de commutation de la capacité de compensation (SW2, SW3), un état de charge de l'électrode de détection et de la capacité de compensation étant obtenu,
le couplage de l'électrode de détection à la capacité de compensation (C_{K}) au moyen du dispositif de commutation d'électrode de détection (SW1) afin de produire un équilibrage de charge entre la capacité (C_{S}) formée par l'électrode de détection et la capacité de compensation,
le découplage de l'électrode de détection de la capacité de compensation (C_{K}) au moyen du dispositif de commutation d'électrode de détection (SW1), la charge de la capacité de compensation présente grâce à l'équilibrage de charge étant obtenue,
le couplage de la capacité de compensation (C_{K}) à un réseau d'évaluation au moyen d'un dispositif de commutation de réseau d'évaluation (SW4), afin de produire un flux de courant depuis la capacité de compensation à travers le réseau d'évaluation,
le changement de charge d'une capacité de maintien (C_{H}) dans le réseau d'évaluation avec un courant de changement de charge dépendant du flux de courant de la capacité de compensation.

2. Procédé selon la revendication 1, dans lequel les étapes sont répétées sur plusieurs cycles afin de produire un changement de charge répété de la capacité de maintien (C_{H}) et une accumulation de charge sur la capacité de maintien, dans lequel, avant la répétition des étapes :
la capacité de compensation (C_{K}) est découplée du réseau d'évaluation,
l'électrode de détection étant de nouveau couplée à la tension de charge, et
la capacité de compensation étant de nouveau couplée entre la tension de référence et la masse.

3. Procédé selon l'une des revendications 1 ou 2, dans lequel l'état de charge de la capacité de maintien est évalué afin d'obtenir une valeur de mesure pour la capacité de l'électrode de détection.

4. Procédé selon la revendication 3, dans lequel on modifie la grandeur de la tension de référence (U_{REF}) en fonction de la valeur de mesure.

5. Procédé selon la revendication 3 ou 4, dans lequel on modifie la grandeur de la capacité de compensation (C_{K}) en fonction de la valeur de mesure.

6. Procédé selon l'une des revendications précédentes, dans lequel le flux de courant de la capacité de compensation (C_{K}) est renforcé jusqu'au courant de changement de charge de la capacité de maintien (C_{H}).

7. Dispositif de détection pour la détection d'approches avec une électrode de détection capacitive, dans lequel
un dispositif de commutation d'électrode de détection (SW1) est prévu, et l'électrode de détection étant couplée au dispositif de commutation d'électrode de détection,
dans lequel une source de tension de charge (U0) est couplée au dispositif de commutation d'électrode de détection (SW1),
dans lequel une capacité de compensation (C_{K}) est réalisée, laquelle est couplée à au moins un dispositif de commutation de la capacité de compensation (SW2, SW3),
dans lequel une source de tension de référence (U_{REF}) est couplée au dispositif de commutation de la capacité de compensation,
dans lequel le dispositif de commutation de la capacité de compensation (SW2, SW3) peut être commandé pour coupler la capacité de compensation à la source de tension de référence (U_{REF}) et la masse pour la charge de la capacité de compensation, ou bien pour la découpler de la source de tension de référence (U_{REF}) pour obtenir la charge,
dans lequel un réseau d'évaluation est formé, lequel peut être couplé à la capacité de compensation (C_{K}) par l'intermédiaire d'un dispositif de commutation de réseau d'évaluation (SW4), dans lequel le réseau d'évaluation présente au moins une capacité de maintien (C_{H}),
dans lequel le dispositif de commutation d'électrode de détection (SW1) peut être commandé pour coupler l'électrode de détection au moins à la source de tension de charge (U0) et en variante, à la capacité de compensation.

8. Dispositif de détection selon la revendication 7, dans lequel le réseau d'évaluation est réalisé afin de renforcer un flux de courant depuis la capacité de compensation (C_{K}) à travers le réseau d'évaluation et assurer le changement de charge de la capacité de maintien avec le flux de courant renforcé.

9. Dispositif de détection selon la revendication 7 ou 8, dans lequel la source de tension de référence (U_{REF}) est réalisée en tant que source de tension avec une tension continue modifiable.

10. Dispositif de détection selon l'une des revendications 7 à 9, dans lequel la capacité de compensation (C_{K}) est formée à partir d'un réseau de capacités, dans lequel différentes capacités peuvent être commutées pour la formation de la capacité de compensation.

11. Dispositif de détection selon l'une des revendications 7 à 10, dans lequel la capacité de maintien est couplée à un prélèvement de tension pour la détection de l'état de charge de la capacité de maintien.

12. Dispositif de détection selon l'une des revendications précédentes, dans lequel le couplage du réseau d'évaluation à la capacité de compensation est réalisé par l'intermédiaire d'un transistor, dans lequel la capacité de compensation peut être couplée à la base du transistor et dans lequel, dans la ligne d'émetteur-collecteur du transistor, la capacité de maintien est couplée entre le transistor et une source de tension continue, et de l'autre côté du transistor, la masse pouvant être couplée au transistor de sorte qu'un flux de courant depuis la capacité de compensation à travers la base du transistor provoque un courant de changement de charge renforcé à travers la ligne d'émetteur-de base du transistor, et ainsi à travers le condensateur de maintien.
